Europäisches Patentamt

European Patent Office

Office européen des brevets

(11) Numéro de publication: **0 278 300 B1**

(12) **FASCICULE DE BREVET EUROPEEN**

(45) Date de publication de fascicule du brevet: **03.06.92**  (51) Int. Cl.5: **H03B** **5/18,** H03B 9/14

(21) Numéro de dépôt: **88101019.3**

(22) Date de dépôt: **25.01.88**

(54) Générateur d'ondes millimétriques à haute stabilité, agile en fréquence.

(30) Priorité: **28.01.87 FR 8701008**

(43) Date de publication de la demande:
**17.08.88 Bulletin 88/33**

(45) Mention de la délivrance du brevet:
**03.06.92 Bulletin 92/23**

(84) Etats contractants désignés:
**DE FR GB IT NL SE**

(56) Documents cités:
**EP-A- 0 013 174      EP-A- 0 060 174**
**FR-A- 2 438 937      FR-A- 2 499 784**
**GB-A- 1 254 623      US-A- 4 155 051**

**PATENT ABSTRACTS OF JAPAN, vol. 6, no.**
**170 (E-128)[1048], 3 septembre 1982; & JP-**
**A-57 87 209 (MITSUBISHI DENKI K.K.)**
**31.05.1982**

**PATENT ABSTRACTS OF JAPAN, vol. 4, no.**
**181 (E-37)[663], 13 décembre 1980; & JP-A-55**
**123 206 (MITSUBISHI DENKI K.K.) 22.09.1980**

(73) Titulaire: **ALCATEL TELSPACE**
**5, rue Noel Pons**
**F-92734 Nanterre Cédex(FR)**

(72) Inventeur: **Mettoudi, Isaac**
**22 rue de Lorraine**
**F-92300 Levallois Perret(FR)**

(74) Mandataire: **Weinmiller, Jürgen et al**
**Lennéstrasse 9 Postfach 24**
**W-8133 Feldafing(DE)**

Rank Xerox (UK) Business Services

## Description

L'invention se rapporte à un générateur d'ondes millimétriques.

La nouvelle génération de faisceaux hertziens et de relais mobiles en ondes millimétriques nécessite de plus en plus l'emploi de sources à haute stabilité qui puissent également être agiles en fréquence.

Un des moyens de l'art connu consiste à utiliser un oscillateur comportant un composant à l'état solide, stabilisé grâce à un résonateur diélectrique.

Le document US-A-4357582 décrit un oscillateur hyperfréquence comprenant un transistor à effet de champ AsGa ayant ses électrodes reliées à trois lignes de transmission disposées sur un substrat, la première ligne de transmission, connectée à sa grille, étant terminée par une impédance d'adaptation, la seconde ligne de transmission, connectée à son drain, étant disposée selon un angle déterminé par rapport à la première ligne de transmission, la troisième ligne de transmission, connectée à sa source, permettant de fournir l'oscillation de sortie ; un résonateur diélectrique étant disposé à l'intérieur de l'angle formé par la deuxième, et la troisième ligne de transmission.

Un tel dispositif, bien qu'ayant une bonne stabilité et une bonne tenue en puissance, présente cependant l'inconvénient de ne pouvoir être agile en fréquence. En effet, pour changer la fréquence de résonance d'un tel résonateur diélectrique il faut soit changer ses dimensions mécaniques, soit changer son réglage : par l'enfoncement d'une vis au-dessus du résonateur diélectrique, par exemple.

Un autre moyen de l'art connu consiste à utiliser un oscillateur comportant un composant solide stabilisé grâce à une bille de grenat YIG (YTTRIUM IRON GARNET).

Ainsi le document FR-A-2499784 décrit un oscillateur hyperfréquence à large bande d'utilisation dont la fréquence est accordée par une petite bille de grenat d'YTTRIUM et de fer disposée dans un champ magnétique réglable, réalisé principalement sous la forme d'un circuit en microbandes gravé sur un substrat en céramique diélectrique et comportant notamment un composant actif polarisé dans une zone à impédance différentielle négative, et un circuit d'adaptation d'impédance.

Un tel dispositif, bien qu'ayant une bonne stabilité tout en permettant l'agilité de fréquence, présente cependant l'inconvénient de ne pouvoir supporter beaucoup de puissance.

Le dispositif de la présente invention permet de surmonter de tels inconvénients.

Les résonateurs diélectriques ont la propriété de pouvoir stabiliser, entre autres choses, la fréquence d'un oscillateur à l'état solide (GUNN OU TRANSISTOR). La fréquence de résonance d'un résonateur diélectrique est fonction de la constante diélectrique du matériau, de sa géométrie et des conditions aux limites. En faisant varier l'un de ces paramètres on peut changer la fréquence de résonance du résonateur diélectrique.

L'invention décrit un moyen pratique et particulièrement intéressant de changer la fréquence de résonance d'un résonateur diélectrique en le plaçant au voisinage immédiat d'un matériau ferrimagnétique tel qu'un grenat de YIG (YTTRIUM IRON GARNET).

L'invention propose donc un générateur d'ondes millimétriques à variation de fréquence, comprenant :

- un résonateur diélectrique ;
- un élément en matériau ferrimagnétique (14) associé à ce résonateur diélectrique ;
- un électro-aimant qui fournit un champ magnétique externe de manière à magnétiser cet élément en matériau ferrimagnétique caractérisé en ce qu'il comprend :
- un composant actif à résistance négative ;
- une diode à capacité variable couplée à ce composant, et en ce que le résonateur diélectrique et l'élément en matériau ferrimagnétique sont réalisés par deux disques accolés l'un à l'autre par l'une de leurs faces.

Un tel ensemble élément en matériau ferrimagnétique associé à un résonateur diélectrique présente l'avantage de pouvoir supporter une puissance hyperfréquence nettement supérieure à celle d'un matériau ferrimagnétique ordinaire. Par ailleurs le coefficient de surtension en charge dans la plage d'accord est plus uniforme que dans le cas d'un réglage par vis au dessus du résonateur diélectrique.

Avantageusement, le résonateur diélectrique et l'élément en matériau ferrimagnétique sont deux disques accolés l'un à l'autre par l'une de leurs faces.

Dans une première réalisation, l'invention propose plus particulièrement un générateur qui comprend une première et une seconde cavités solidaires l'une de l'autre et couplées entre elles ; le composant actif étant situé dans la première cavité et l'ensemble résonateur diélectrique + élément en matériau ferrimagnétique dans la seconde cavité. Le composant actif à résistance négative étant une diode gunn, et la première cavité contient cette diode gunn et la diode à capacité variable qui sont couplées entre elles, un premier iris de couplage permettant l'adaptation de cette cavité à un guide de sortie, et un second iris de couplage, situé entre cette première cavité et la seconde cavité, permettant le couplage de ces deux cavités.

Dans une seconde réalisation, l'invention propose plus particulièrement une première et une seconde cavités solidaires l'une de l'autre et couplées entre elles ; le composant actif étant situé dans la première cavité et l'ensemble résonateur diélectrique élément en matériau ferrimagnétique dans la seconde cavité, le composant actif étant une diode gunn ; une troisième cavité étant couplée à la seconde cavité à l'aide d'un troisième iris de couplage située à l'autre côté de cette cavité par rapport à la première cavité, la diode à capacité variable étant fixée à l'intérieur de cette troisième cavité.

Dans une troisième réalisation, l'invention propose plus particulièrement un générateur dans lequel le composant à résistance négative est un transistor et qui comprend un substrat sur lequel sont disposées au moins trois pistes microruban, le transistor ayant deux électrodes reliées respectivement à une première et à une troisième piste, la diode à capacité variable étant reliée à une deuxième piste, l'ensemble résonateur diélectrique + élément ferrimagnétique étant couplé aux première et deuxième pistes qui sont situées de part et d'autre de celui-ci.

Les caractéristiques et avantages de l'invention ressortiront d'ailleurs de la description qui va suivre, à titre d'exemple non limitatif, en référence aux figures annexées sur lesquelles :
- la figure 1 représente une vue schématique du dispositif de l'invention,
- la figure 2 représente une vue en coupe longitudinale d'une première réalisation du dispositif de l'invention,
- les figures 3 et 4 représentent deux coupes selon les plans III-III et IV-IV de la première réalisation du dispositif de l'invention représentée à la figure 2,
- la figure 5 représente une vue en coupe longitudinale d'une seconde réalisation du dispositif selon l'invention,
- la figure 6 représente une coupe selon le plan VI-VI de la seconde réalisation représentée à la figure 5,
- la figure 7 représente une coupe longitudinale d'une troisième réalisation du dispositif selon l'invention.

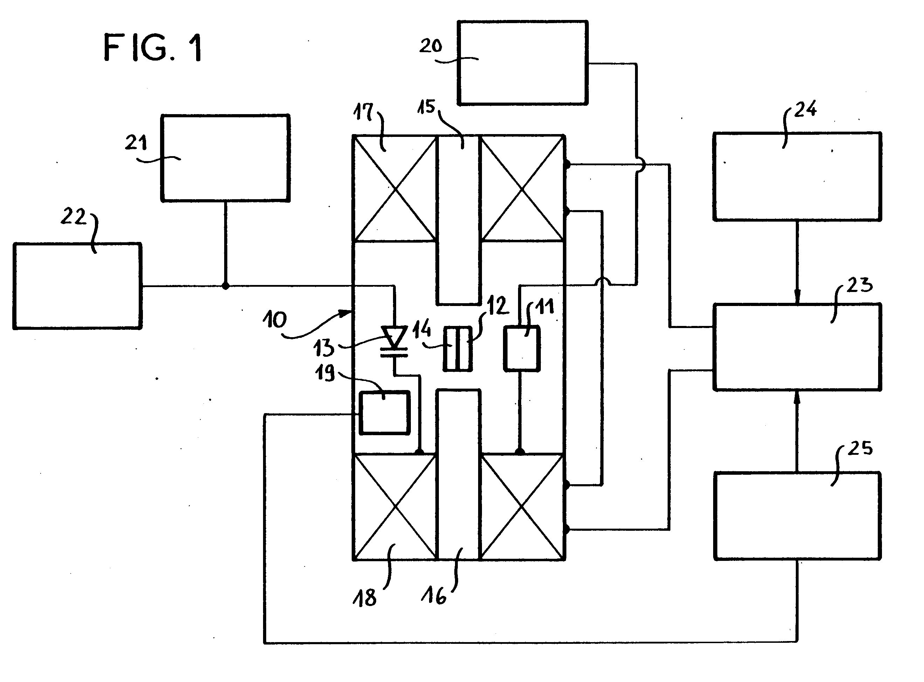

Le générateur d'ondes millimétriques selon l'invention, comme représenté à la figure 1, comprend les éléments suivants :
- un ensemble oscillateur 10 comportant un élément électronique actif 11 à résistance négative, tel que par exemple une diode gunn ;
- un résonateur diélectrique 12, par exemple un disque de titanate de zirconium, qui permet de stabiliser la fréquence de l'ensemble oscillateur ;
- une diode à capacité variable 13, par exemple un varactor, couplé à cet élément 11 à résistance négative qui permet une modulation en fréquence et une modification de la fréquence d'accord de l'ensemble oscillateur ;
- un élément ferrimagnétique 14, tel qu'un disque grenat de YIG (YTTRIUM IRON GARNET), accolé au résonateur diélectrique 12 pour pouvoir faire varier ainsi les conditions aux limites de ce résonateur diélectrique 12 ;
- un électroaimant (15, 16, 17, 18) qui fournit un champ magnétique externe capable de magnétiser l'élément ferrimagnétique 14;
- un capteur de température 19, par exemple un élément semi-conducteur.

L'élément électronique actif à résistance négative 11 est polarisé au moyen d'une source d'alimentation 20 qui délivre, par exemple, une tension continue d'alimentation stable.

La diode à capacité variable 13, qui est polarisée au moyen d'une source d'alimentation 21, reçoit le signal de sortie d'un circuit 22 de modulation de fréquence.

L'électro-aimant, formé de deux barreaux de fer doux 15 et 16 constituant ses deux pôles nord et sud et de deux bobinages 17 et 18, est relié à un circuit d'alimentation en courant 23 commandé par un circuit de commande des canaux de fréquence 24.

L'accord de fréquence est obtenu en magnétisant le disque de YIG à l'aide d'un champ magnétique externe fourni par cet électro-aimant. Un changement de la fréquence de résonance peut être ainsi facilement réalisé en modifiant le champ magnétique appliqué sur l'ensemble disque YIG 14 + disque titanate de zirconium 12.

L'agilité en fréquence de l'oscillateur utilisant un composant à l'état solide est obtenu alors par simple changement du courant circulant dans la bobine de l'electro-aimant.

A chaque commande ou télécommande de canal de fréquence correspond un train d'impulsions fixé à l'avance. Les trains d'impulsions sont traités par des circuits prévus à cet effet de manière à faire correspondre dans l'électro-aimant un palier de courant donné pour chaque canal de fréquence.

Afin d'augmenter la stabilité de l'ensemble oscillateur, une stabilisation complémentaire a été réalisée grâce à une boucle ouverte. Cet ensemble complémentaire de stabilisation comprend notamment le capteur de température 19. L'information température est traitée à l'aide de circuits de traitement 25, connus de l'homme de l'art, prévus à cet effet. Il en résulte un signal qui vient s'appliquer sur la commande de courant (23) de l'électro-aimant de manière à corriger la dérive de l'oscillateur en fonction de la température.

Le montage selon l'invention présente donc les caractéristiques suivantes :
- La puissance hyperfréquence est fournie par l'élément à résistance négative ;

- La modulation de fréquence est réalisée en appliquant une tension variable sur le varactor 13 couplé à l'élément à résistance négative 11;
- La stabilité de fréquence est obtenue grâce au résonateur diélectrique 12 qui présente un coefficient Q en charge élevé ;
- L'agilité de fréquence est obtenue en faisant varier la fréquence de résonance de ce résonateur diélectrique 12.

Le matériau ferrimagnétique 14 accolé au résonateur diélectrique 12 et soumis au champ magnétique externe fourni par l'électro-aimant, modifie plus ou moins considérablement les conditions aux limites du résonateur diélectrique 12 en fonction de l'intensité du champ magnétique. De ce fait il suffit simplement de change le courant circulant dans la bobine de l'électro-aimant pour changer la fréquence de résonance du résonateur diélectrique 12, et par voie de conséquence la fréquence de l'oscillateur. On comprend alors tout l'intérêt d'un tel dispositif d'autant plus que l'ensemble YIG + Résonateur diélectrique permet de supporter des puissances hyperfréquences relativement élevées.

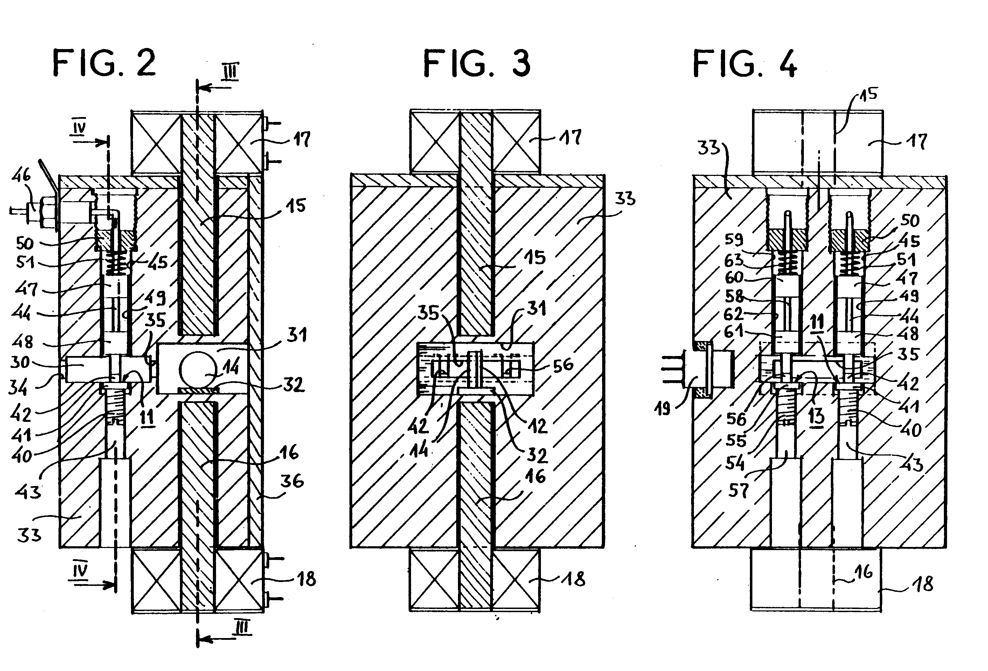

Une première réalisation de l'invention est représentée aux figures 2, 3 et 4.

Dans cette réalisation l'ensemble oscillateur comprend :

- une première cavité oscillatrice 30 dans laquelle sont disposés l'élément électronique actif 11 à résistance négative, qui peut être une diode gunn, et la diode à capacité variable 13 couplé à cette diode ;
- une seconde cavité 31, solidaire de la première et couplé à celle-ci, dans laquelle est disposée l'ensemble des deux disques 12 et 14, respectivement de titanate de zirconium et de YIG par exemple, accolés et situés debout sur leur tranche sur un support 32, par exemple en quartz.

Ces deux cavités sont formées par deux alésages rectangulaires situés dans le prolongement l'un de l'autre, réalisés dans un bloc métallique parallélépipédique perpendiculairement à deux de ses faces. Les deux disques 12 et 14 accolés ont leurs faces qui sont parallèles au petit côté de ces alésages. Les barreaux 15 et 16 de fer doux de l'électro-aimant sont disposés dans deux alésages perpendiculaires à la direction des deux cavités 30 et 31.

Un premier iris de couplage 34 est disposé à l'extrémité avant de la première cavité 30 pour permettre l'adaptation à un guide de sortie non représenté sur la figure.

Un deuxième iris de couplage 35 situé à l'arrière de cette première cavité 30 permet le couplage à la deuxième cavité 31 contenant l'ensemble disque cylindrique YIG 14 + disque cylindrique 12 en titanate de zirconium.

Une plaque métallique 36 permet d'obturer la deuxième cavité 31 et joue donc le rôle d'un court-circuit arrière.

La diode gunn 11 comprend un boîtier, noyé dans le bloc métallique 33, comportant une partie filetée 40, une collerette 41 et une borne active 42. La partie filetée 40 s'engage dans un trou taraudé 43 dont l'axe longitudinal est perpendiculaire à la direction de la cavité 30. La collerette 41 repose à l'intérieur d'un lamage de sorte que, la borne active 42 ressort en saillie de la face intérieure de la cavité. La borne active 42 est placée en contact avec l'extrémité de la tige d'alimentation cylindrique 44 qui est engagée dans un trou cylindrique 45, d'axe longitudinal confondu avec l'axe longitudinal du trou 43 et dont l'extrémité inférieure débouche par la face intérieure de la cavité. L'extrémité supérieure de la tige 44 est reliée à un filtre d'entrée 46. L'extrémité inférieure de la tige d'alimentation 27 comprend plusieurs épaulements 47 et 48 de longueurs respectives, égales approximativement au quart de la longueur d'onde de la fréquence de résonance de la cavité et espacés entre eux d'une longueur équivalente, de manière à former un filtre hyperfréquence qui empêche la puissance hyperfréquence de remonter vers l'extrémité supérieure de la tige d'alimentation. Une gaine thermodurcissable 49 entoure les épaulements 47 et 48 du filtre pour isoler la tige d'alimentation 44 de l'enveloppe métallique 33 de la cavité. L'isolement de la tige 44 est complété dans sa partie supérieure par un bouchon d'isolement 50 vissé dans la partie supérieure du trou 45 et entourant entièrement l'extrémité supérieure de la tige 44. Un ressort hélicoïdal 51 entoure une partie d'extrémité de la tige 44 et est comprimé entre l'extrémité du bouchon isolant 50 et l'épaulement 47 pour maintenir la tige d'alimentation 44 contre la borne active 42 de la diode 11.

De façon équivalente la diode à capacité variable 13 comporte une partie filetée 54, une collerette 55 et une borne active 56. La partie filetée 54 s'engage dans un trou taraudé 57 dont l'axe longitudinal est perpendiculaire à la direction de la cavité 30. La collerette 55 repose à l'intérieur d'un lamage pratiqué sur la face interne de la cavité. Comme précédemment la borne active 56 est en saillie à la surface de la face de la cavité 30 et est en contact avec l'extrémité d'une tige d'alimentation cylindrique 58 engagée dans un trou cylindrique 59, d'axe longitudinal confondu avec l'axe longitudinal du trou 57 et débouchant dans sa partie inférieure par la face interne de la cavité. L'extrémité supérieure de la tige 58 est reliée à une borne d'alimentation. L'extrémité inférieure de la tige d'alimentation 58 comprend plusieurs épaulements 60 et 61 séparés entre eux et de longueurs égales au quart de la longueur d'onde de la fréquence de résonance de la cavité, pour former un filtre hyperfréquence et empêcher la puissance hyperfréquence engendrée à l'intérieur de la cavité de remonter le long de la tige d'alimentation 58. Les parties d'épaulements 60 et 61 sont entourées par une gaine isolante thermodurcissable 62 ou tout autre moyen équivalent pour isoler le courant continu d'alimentation de la diode de l'enveloppe 33. L'extrémité supérieure de la tige 41 est entourée par un bouchon isolant vissé à l'intérieur de l'enveloppe. Comme précédemment, un ressort hélicoïdal 63 entoure la tige d'alimentation 58 dans sa partie supérieure et est comprimé entre une extrémité du bouchon et l'épaulement de la tige, de façon à maintenir appuyée l'extrémité inférieure de la tige contre la borne active de la diode.

Le capteur en température 19 est fixé dans le boîtier 33.

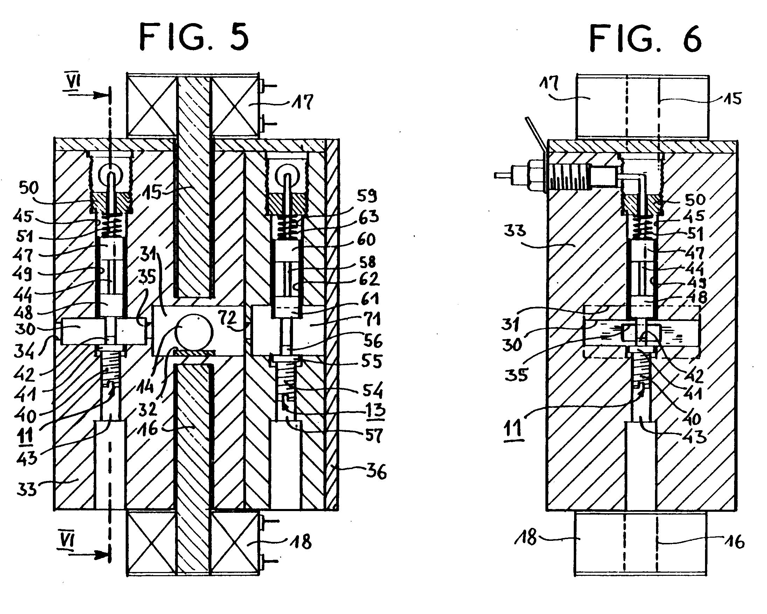

Une seconde réalisation de l'invention est représentée aux figures 5 et 6.

Une troisième cavité 71 située dans le prolongement des deux premières cavités 30 et 31 contient la diode à capacité variable 13, alors que la première cavité ne contient plus que la diode gunn 11.

Cette troisième cavité 71 est un alésage réalisé dans le bloc métallique 33. Elle est couplée à la cavité centrale 31 à l'aide d'un troisième iris de couplage 72.

La plaque 36 de court-circuit arrière est donc fixée à la sortie de cette troisième cavité.

L'alimentation de la diode gunn 11 et de la diode à capacité variable 13 est réalisée de façon similaire à celle représentée aux figures 2 à 4.

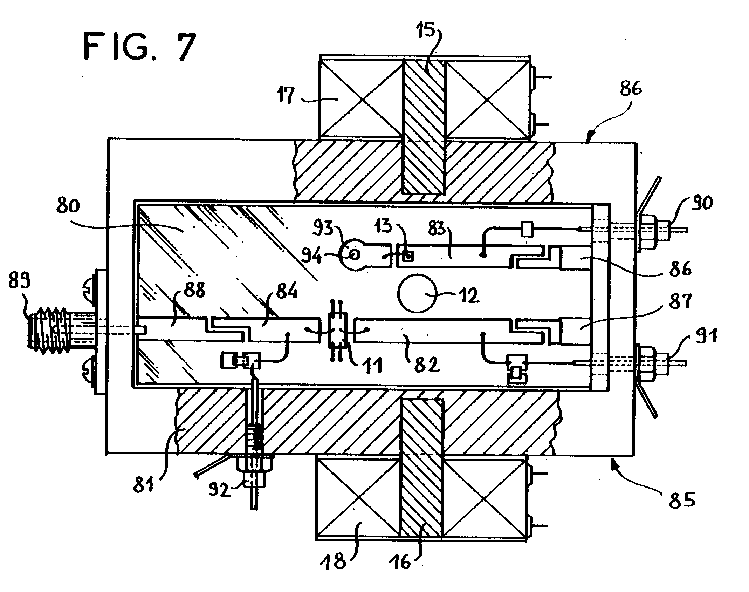

Une troisième réalisation de l'invention est représentée à la figure 7.

Un substrat 80 est disposé à l'intérieur d'un boîtier métallique 81 parallélépipédique.

L'électro-aimant (15, 16, 17 et 18) est fixé sur les cotés de ce boîtier, ses barreaux de fer doux étant introduits dans deux alésages réalisés dans ce boîtier perpendiculairement à ses faces allongées 85 et 86.

Trois pistes microruban 82, 83 et 84 parallèles à ces faces 85 et 86 sont disposées sur le substrat 80, les deux premières 82 et 83 parallèles entre elles étant couplées à deux charges de 50 86 et 87, et la troisième piste 84, située dans le prolongement de la première 82, étant couplée à une quatrième ligne 88 reliée à une fiche de sortie hyperfréquence 89.

L'élément électronique actif à résistance négative 11, qui ici est un transistor par exemple FET ASGA, a deux de ses électrodes reliées respectivement à la première (82) et la troisième (84) piste.

La diode à capacité variable 13 est reliée d'une part par la seconde piste 83 à un filtre d'entrée 90, d'autre part à la masse via un élément de piste 13 et un trou métallisé de masse 94.

L'ensemble résonateur diélectrique 12 + élément ferrimagnétique 14 est couplé à la première (82) et à la deuxième (83) pistes qui sont situées de part et d'autre de celui-ci.

Le transistor 11 est utilisé, par d'exemple, en source commune.

La première piste 82 est reliée à un filtre d'alimentation grille 91.

La troisième ligne est reliée, elle, à un filtre d'alimentation drain 92.

Le dispositif de la présente invention présente donc l'avantage, par rapport aux sources hyperfréquences déjà existantes, de pouvoir allier une haute stabilité à une bonne agilité de fréquence, ce qui le rend particulièrement intéressant pour des faisceaux hertziens, des relais mobiles et le domaine des télécommunications en général.

Ces sources peuvent délivrer une puissance allant de quelques dizaines de milliwatts à quelques centaines de milliwatts et leur domaine de fréquence d'utilisation peut s'étendre de quelques gigaherts jusqu'aux ondes millimètriques à 30 GHZ et au delà.

Il est bien entendu que la présente invention n'a été décrite et représentée qu'à titre d'exemple préférentiel et que l'on pourra remplacer ses éléments constitutifs par des éléments équivalents sans pour autant, sortir du cadre de l'invention.

Ainsi dans les deux premières réalisations, le bloc métallique peut être composé de plusieurs parties correspondant à chacune des cavités et qui sont solidarisées les unes aux autres.

**Revendications**

1. Générateur d'ondes millimétriques à variation de fréquence, comprenant :
   - un résonateur diélectrique (12) ;
   - un élément en matériau ferrimagnétique (14) associé à ce résonateur diélectrique (12) ;
   - un électro-aimant (15, 16, 17, 18) qui fournit un champ magnétique externe de manière à magnétiser cet élément en matériau ferrimagnétique (14) caractérisé en ce qu'il comprend :
   - un composant actif (11) à résistance négative ;
   - une diode à capacité variable (13) couplée à ce composant, et en ce que le résonateur diélectrique (12) et l'élément en matériau ferrimagnétique (14) sont réalisés par deux disques (12, 14) accolés l'un à l'autre par l'une de leurs faces.

2. Générateur selon la revendication 1, caractérisé en ce que le résonateur diélectrique (12) est un disque de titanate de zirconium, et en ce que l'élément en matériau ferrimagnétique (14) est un disque en YTTRIUM IRON GARNET (YIG).

3. Générateur selon l'une quelconque des revendications précédentes, caractérisé en ce qu'il comprend un capteur de température (19).

4. Générateur selon l'une quelconque des revendications précédentes, caractérisé en ce qu'il comprend une première (30) et une seconde (31) cavités solidaires l'une de l'autre et couplées entre elles ; le composant actif (11) étant situé dans la première cavité (30) et l'ensemble résonateur diélectrique (12) + élément en matériau ferrimagnétique (14) dans la seconde cavité (31).

5. Générateur selon la revendication 4, caractérisé en ce que le composant actif à résistance négative (11) est une diode gunn, et en ce que la première cavité (30) contient cette diode gunn ainsi que la diode à capacité variable (13) qui sont couplées entre elles, un premier iris de couplage (34) permettant l'adaptation de cette cavité à un guide de sortie, et un second iris de couplage (35), situé entre cette première cavité et la seconde cavité, permettant le couplage de ces deux cavités (30, 31).

6. Générateur selon la revendication 4, caractérisé en ce que le composant actif (11) est une diode gunn, et en ce qu'il comprend une troisième cavité (71), couplée à la seconde cavité à l'aide d'un troisième iris de couplage (72), située de l'autre côté de cette cavité (31) par rapport à la première cavité (30) ; la diode à capacité variable (13) étant fixée à l'intérieur de cette troisième cavité.

7. Générateur selon l'une quelconque des revendications 1 ou 2, caractérisé en ce que le composant à résistance négative (11) est un transistor et en ce que ledit générateur comprend un substrat (80) sur lequel sont disposées au moins trois pistes microruban (82, 83, 84), le transistor ayant deux électrodes reliées respectivement à une première (82) et à une troisième (84) piste, la diode à capacité variable (13) étant reliée à une deuxième piste (83), l'ensemble résonateur diélectrique (12) + élément ferrimagnétique (14) étant couplé aux première (82) et deuxième (83) pistes qui sont située de part et d'autre de celui-ci.

8. Générateur selon la revendication 7, caractérisé en ce que le transistor est un transistor FET AsGa monté en source commune.

## Claims

1. Variable frequency millimetre wave generator comprising:
   - a dielectric resonator;
   - a ferrimagnetic material member (14) associated with said dielectric resonator;
   - an electromagnet which provides an external magnetic field to magnetise said ferrimagnetic material member characterised in that it comprises:
   - a negative resistance active component;
   - a variable capacitance diode connected to said component, and in that the dielectric resonator and the ferrimagnetic material member are formed by two disks in contact through one of their sides.

2. Generator according to claim 1 characterised in that the dielectric resonator (12) is a zirconium titanate disc and in that the ferrimagnetic material member (14) is an YTTRIUM IRON GARNET (YIG) disc.

3. Generator according to either of the preceding claims characterised in that it comprises a temperature sensor (19).

4. Generator according to any one of the preceding claims characterised in that it comprises a first cavity (30) and a second cavity (31) fastened and coupled to each other; the active component (11) being disposed in the first cavity (30) and the dielectric resonator (12) + ferrimagnetic member (14) combination in the second cavity (31).

5. Generator according to claim 4 characterised in that the negative resistance active component (11) is a Gunn diode and in that the first cavity (30) contains said Gunn diode and the variable capacitance diode (13) which are coupled to each other, a first coupling iris (34) enabling matching of said cavity to an output guide and a second coupling iris (35) disposed between said first cavity and the second cavity enabling coupling of said two cavities (30, 31).

6. Generator according to claim 4 characterised in that the active component (11) is a Gunn diode and in that it comprises a third cavity (71) coupled to the second cavity by means of a third coupling iris (72) situated on the opposite side of said cavity (31) to the first cavity (30); the variable capacitance diode (13) being fixed to the interior of said third cavity.

7. Generator according to claim 1 or claim 2 characterised in that the negative resistance component (11) is a transistor and in that said generator comprises a substrate (8) on which are disposed at least three microstrip tracks (82, 83, 84), the transistor having two electrodes respectively connected to a first track (82) and to a third track (84) the variable capacitance (30) being connected to a second track (83), the dielectric resonator (12) + ferrimagnetic member (14) combination being coupled to the first track (82) and the second track (83) which are situated on each side of this combination.

8. Generator according to claim 7 characterised in that the transistor is an AsGa FET in a common source configuration.

**Patentansprüche**

1. Millimeterwellengenerator mit variabler Frequenz, mit
   - einem dielektrischen Resonator (12),
   - einem Element aus ferrimagnetischem Material (14), das diesem dielektrischen Resonator (12) zugeordnet ist,
   - einem Elektromagneten (15, 16, 17, 18), der ein äußeres Magnetfeld liefert, um dieses Element (14) aus ferrimagnetischem Material zu magnetisieren, dadurch gekennzeichnet, daß er aufweist:
   - ein aktives Bauelement (11) mit negativem Widerstand,
   - eine Diode mit variabler Kapazität (13), die mit diesem Bauelement verbunden ist,
   
   und daß der dielektrische Resonator (12) und das Element aus ferrimagnetischem Material (14) aus zwei Scheiben (12, 14) hergestellt sind, die über eine ihrer Flächen aneinandergefügt sind.

2. Generator nach Anspruch 1, dadurch gekennzeichnet, daß der dielektrische Resonator (12) eine Scheibe aus Zirkontitanat ist und daß das Element aus ferrimagnetischem Material (14) eine Scheibe aus Yttrium-Eisen-Granat (YIG) ist.

3. Generator nach einem beliebigen der vorhergehenden Ansprüche, dadurch gekennzeichnet, daß er eine Temperatursonde (19) aufweist.

4. Generator nach einem beliebigen der vorhergehenden Ansprüche, dadurch gekennzeichnet, daß er in einem gemeinsamen Block einen ersten (30) und einen zweiten Hohlraum (31) aufweist, die miteinander gekoppelt sind, wobei das aktive Bauelement (11) sich in dem ersten Hohlraum (30) und die aus dem dielektrischer Resonator (12) und de, Element aus ferrimagnetischem Material (14) gebildete Baugruppe sich im zweiten Hohlraum (31) befindet.

5. Generator nach Anspruch 4, dadurch gekennzeichnet, daß das aktive Bauelement mit negativem Widerstand (11) eine Gunn-Diode ist und daß der erste Hohlraum (30) diese Gunn-Diode wie auch die Diode mit variabler Kapazität (13) enthält, die untereinander gekoppelt sind, wobei eine erste Koppelblende (34) die Anpassung dieses Hohlraums an einen Ausgangshohlleiter ermöglicht und eine zweite Koppelblende (35), die sich zwischen diesem ersten Hohlraum und dem zweiten Hohlraum befindet, die Kopplung dieser beiden Hohlräume (30, 31) erlaubt.

6. Generator nach Anspruch 4, dadurch gekennzeichnet, daß das aktive Bauelement (11) eine Gunn-Diode ist und daß er einen dritten Hohlraum (71) aufweist, der mit dem zweiten Hohlraum über eine dritte Koppelblende (72) gekoppelt ist, die sich auf der anderen Seite dieses Hohlraums (31) in Bezug auf den ersten Hohlraum (30) befindet, wobei die Diode mit variabler Kapazität (13) im Inneren dieses dritten Hohlraums befestigt ist.

7. Generator nach einem der Ansprüche 1 oder 2, dadurch gekennzeichnet, daß das Bauelement mit negativem Widerstand (11) ein Transistor ist und daß dieser Generator ein Substrat (80) aufweist, auf dem mindestens drei Mikrostreifen (82, 83, 84) angeordnet sind, wobei zwei Elektroden des Transistors an einen ersten (82) bzw. einen dritten Streifen (84) gekoppelt sind und die Diode mit variabler Kapazität (13) an einen zweiten Streifen (83) gekoppelt ist und wobei die Baugruppe aus dielektrischem Resonator (12) und ferrimagnetischem Element (14) an den ersten (82) und zweiten Streifen (83) gekoppelt ist, die sich zu beiden Seiten dieser Baugruppe befinden.

8. Generator nach Anspruch 7, dadurch gekennzeichnet, daß der Transistor ein FET AsGa-Transistor ist, der in Source-Basisschaltung angeordnet ist.

FIG. 1

# FIG. 2

# FIG. 3

# FIG. 4

EP 0 278 300 B1

FIG. 6

FIG. 5

FIG. 7